# EUROPÄISCHE PATENTSCHRIFT

(11) **EP 1 114 460 B1**
(45) Veröffentlichungstag und Bekanntmachung des Hinweises auf die Patenterteilung: **17.10.2007**
(21) Anmeldenummer: 99944441.7
(22) Anmeldetag: 18.08.1999
(51) Int. Cl.: H01L 23/58

(54) **HALBLEITERCHIP MIT OBERFLÄCHENABDECKUNG**
SEMICONDUCTOR CHIP WITH SURFACE COATING
PUCE A SEMI-CONDUCTEUR AVEC REVETEMENT DE SURFACE

(30) Priorität: 18.08.1998 EP 98115550
(43) Veröffentlichungstag der Anmeldung: 11.07.2001
(73) Patentinhaber: Infineon Technologies AG, 81669 München (DE)
(72) Erfinder: SMOLA, Michael, D-80636 München (DE); BRÜCKLMEIER, Eric-Roger, D-80634 München (DE)
(74) Vertreter: Epping - Hermann - Fischer
(86) Internationale Anmeldenummer: PCT/EP1999/006077
(87) Internationale Veröffentlichungsnummer: WO 2000/011719

(56) Entgegenhaltungen:
- EP-A- 0 169 941
- EP-A- 0 300 864
- EP-A- 0 378 306
- EP-A- 0 510 434
- EP-A- 0 771 030
- DE-A- 4 018 688
- DE-C- 19 639 033
- GB-A- 2 288 048

## Beschreibung

Die Erfindung betrifft einen Halbleiterchip mit in zumindest einer Schicht eines Halbleitersubstrats realisierten, in zumindest einer Gruppe angeordneten Schaltungen und mit zumindest einer leitenden, über zumindest einer solchen Schaltungsgruppe angeordneten und mit zumindest einer der Schaltungen elektrisch verbundenen Schutzschicht.

Ein solcher Halbleiterchip ist aus der EP 0 378 306 A2 bekannt. Beim dortigen Halbleiterchip ist eine erste Schaltungsgruppe in einem gesicherten Bereich und eine zweite Schaltungsgruppe in einem nicht gesicherten Bereich angeordnet. Die Sicherung des ersten Bereiches erfolgt beim bekannten Halbleiterchip durch eine leitende Schicht, die über der Verdrahtungsebene der ersten Schaltungsgruppe angeordnet ist. Diese leitende Schicht ist mit der Schaltungsgruppe elektrisch verbunden, wobei eine ordnungsgemäße Funktion dieser Schaltungsgruppe nur bei intakter Schicht gegeben ist.

Die erste Schaltungsgruppe umfaßt hier einen Mikroprozessor sowie zugehörige Peripherieschaltungen wie Speicher und eine Transferlogikschaltung. In den Speichern können insbesondere geheime Informationen stehen. Es ist auch denkbar, daß der Mikroprozessor eine spezielle Struktur hat, die für sicherheitsrelevante Funktionen besonders gut geeignet ist. Durch die leitende Schicht, deren Unversehrtheit ständig überprüft wird, wird ein Ausspähen mittels beispielsweise eines Rasterelektronmikroskops während des Betriebs der Schaltung verhindert.

Es ist allerdings nach wie vor möglich, die Schutzschicht zu entfernen und Ersatzleitungen zu erzeugen, die nicht über sicherheitskritischen Bereichen liegen. Auf diese Weise kann trotzdem eine Untersuchung der Schaltungen im Betrieb erfolgen, wenn auch nur unter derzeit sehr aufwendigen Bedingungen.

Auch die EP 0 169 941 A1 zeigt eine Halbleiterschaltung mit einer Passivierungsschicht, die als Äquipotentialfläche darunter liegende Schaltungsteile abschirmt. Diese Passivierungsschicht ist als aktive Leiterbahn in eine Sicherheitslogik einbezogen, so daß deren Beseitigung die Funktion des Chips unterbricht und eine dynamische Analyse unmöglich macht. Wenn es allerdings gelingt, statt der abdeckenden Passivierungsschicht eine Art Bypass-Leitung zu legen, die zwar die Leitungsfunktion der Passivierungsschicht erfüllt nicht aber die Abschirmfunktion wird bei dieser bekannten Schutzschaltung die Halbleiterschaltung wieder aktiviert.

Die EP 0 300 864 A2 lehrt das Vorsehen einer leitenden Schutzschicht, die aus zwei Teilschichten besteht, deren Kapazität ausgewertet wird. Das Ersetzen einer oder beider Teilschichten durch andere leitende Strukturen ist dadurch zwar nicht ohne weiteres möglich allerdings würde das Nachbilden der Kapaziät durch andere Strukturen, die zumindest Teile der Schaltungen freilassen, die Sicherheitsvorkehrung umgehen. Jedenfalls kann eine Entfernung der Schichten und ein späteres Wiederaufbringen um zumindest eine statische Untersuchung des Halbleiterchips vorzunehmen später nicht mehr festgestellt werden.

Aus der EP 0 510 434 A2 ist eine Sicherheitsschaltung bekannt, die gegen so genanntes "Reverse Engineering" geschützt ist. Hierzu ist angegeben, mittels einer Diode eine Strahlung zu erfassen, der die Schaltung normalerweise nicht ausgesetzt ist. Als gesicherte Schaltung ist beispielsweise ein Speicher angegeben, dessen Spannungsversorgung als Folge der Strahlung unterbrochen wird.

Eine Methode zur Entfernung von Schichten und auch zum Aufbringen neuer Schichten wie beispielsweise Bypass-Leitungen ist die focussed-ion-beam-(FIB)-Methode. Diese wurde zwar primär zur Fehlerbehebung und Restrukturierung entwickelt, stellt aber eine erhebliche Gefahr für sicherheitskritische Halbleiterchips dar.

Es ist daher die Aufgabe der Erfindung, einen Halbleiterchip anzugeben, der sicher gegen FIB-Angriffe ist.

Die Aufgabe wird gemäß Anspruch 1 dadurch gelöst, daß das Substrat eines Halbleiterchips zumindest einen Schutzsensor aufweist, der derart gebildet ist, daß er einen Zustand nicht-flüchtig speichern kann, und daß der Schutzsensor mit seinem Detektionsanschluß mit der leitenden Schutzschicht oder zumindest einer der leitenden Schutzschichten verbunden ist und ein Ausgangsanschluß des Schutzsensors mit zumindest einer der Schaltungen derart verbunden ist, daß eine bestimmungsgemäße Funktion der Schaltung nicht möglich ist, wenn am Ausgang des Schutzsensors ein definierter, nicht-flüchtiger Signal anliegt.

Ein Schutzsensor kann in vorteilhafter Weise ein Transistor mit gegenüber Transistoren der Schaltungen sehr dünnem Gateoxid sein. Es können aber auch andere als Sicherungen ("fuses") wirkende Bauteile wie Dioden verwendet werden. Wesentlich für ein Bauteil für die Funktion als Schutzsensor ist, daß es durch eine Spannung nicht-flüchtig verändert werden kann.

Nicht-flüchtig heißt in diesem Zusammenhang, daß ein gespeicherter Zustand nicht nur nach dem Abschalten und dem erneuten Wiederanlegen der Versorgungsspannung erhalten bleibt sondern auch, daß ein Abtragen und Wiederaufbringen einer eine Verbindung herstellenden leitenden Schicht detektiert und festgehalten wird. Es kann also auch bei intakter Schicht festgestellt werden, ob sie vorher entfernt worden war oder ob ein Versuch dazu unternommen wurde.

Es hat sich nämlich gezeigt, daß sich die mit der FIB-Methode behandelten Strukturen elektrisch aufladen. Die dadurch erzeute Spannung wird von den Schutzsensoren detektiert und durch Bestandteile der Schaltung(en) ausgewertet. Wenn ein Schutzsensor ein Transistor mit gegenüber Transistoren der Schaltungen sehr dünnem Gateoxid ist wird dieses Gateoxid durch die Spannung aufgrund des Ionenstrahls zerstört. Dies kann in einfacher Weise ausgewertet werden.

Die Schutzsensoren können einerseits flächendeckend auf dem Halbleiterchip verteilt werden andererseits genügt eine geringe Anzahl von Sensoren.

Der besondere Vorteil der Erfindung ist, daß die Entfernung der Schutzschicht in Verbindung mit einer nachträglich aufgebrachten Bypassleitung -für den Fall, daß das Vorhandensein der Schutzschicht überprüft wird- nicht zum Erfolg führt, da der Schutzsensor die Entfernung der Schutzschicht bereits nicht-flüchtig detektiert hat und die Schaltung daher nicht mehr funktioniert und somit weder mit noch ohne Schutzschicht betrieben werden kann. Wesentlich ist hierbei, daß die Manipulation an der Schutzschicht nicht-flüchtig gespeichert ist, was beispielsweise durch die Zerstörung eines Gateoxids erfolgen kann.

In einer weiteren Ausbildung der Erfindung ist ein Schutzsensor als nicht-flüchtige Speicherzelle ausgebildet, die mit beidseitig eines Kanalgebiets in dem Halbleitersubstrat ausgebildeten Drain- und Source-Diffusionsgebieten sowie einer vollständig isolierten, zumindest zum Teil oberhalb des Kanalgebiets angeordneten Gateelektrode und zwei oberhalb der isolierten Gateelektrode angeordneten Steuergateelektroden gebildet ist, wobei eine der Steuergateelektroden den Detektionsanschluß bildet und die andere Steuergateelektrode sowie die Diffusionsgebiete mit einer Auswerteschaltung verbunden sind.

Bei dieser neuartigen nicht-flüchtigen Speicherzelle führt eine durch einen Ionenstrahl verursachte Spannung zu einer Änderung der Ladung auf dem isolierten Gate, die nicht abfließen kann. Über den zweiten Steuergateanschluß sowie die Anschlüsse der Diffusionsgebiete kann der veränderte Zustand der Speicherzelle zu jeder Zeit ausgelesen und damit detektiert werden.

In vorteilhafter Weise ist das isolierte Gate vorgeladen, wobei bei mehreren Schutzsensoren Vorladungen mit unterschiedlicher Polarität aufgebracht werden, was zu einer sichereren Detektion einer Manipulation führt.

Die Erfindung wird nachfolgend anhand eines Ausführungsbeispiels mit Hilfe von Figuren näher erläutert. Dabei zeigen
- Figur 1: eine mögliche Ausbildung einer Schutzschicht,
- Figur 2: das Prinzipschaltbild einer möglichen Auswerteschaltung mit einem erfindungsgemäßen Schutzsensor,
- Figur 3: die Draufsicht auf einen erfindungsgemäßen Schutzsensor in der Ausbildung als nicht-flüchtige Speicherzelle, und
- Figur 4: die Prinzipdarstellung einer Auswerteschaltung in Verbindung mit der nicht-flüchtigen Speicherzelle.

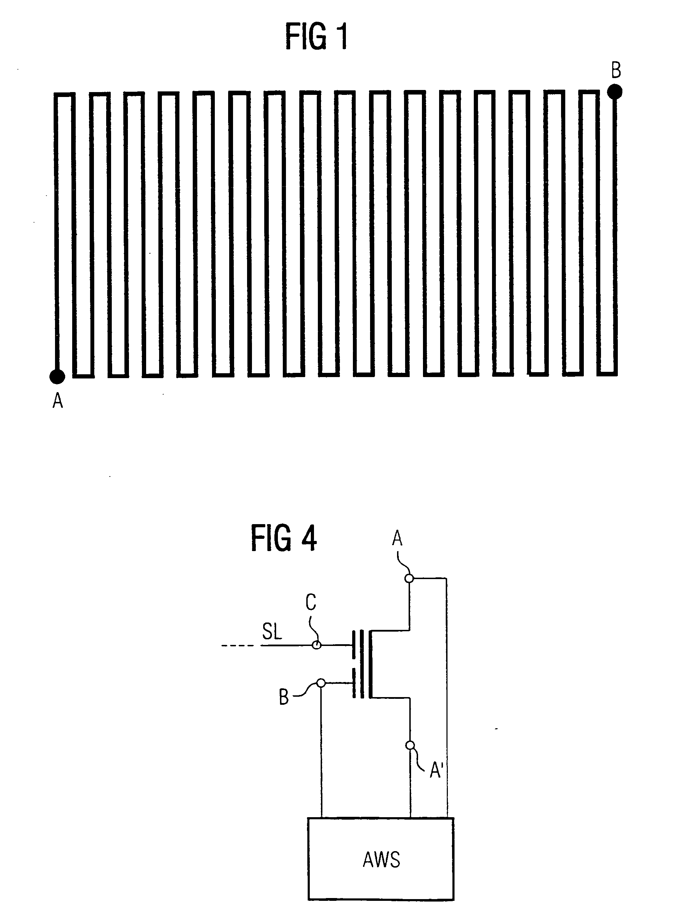

Figur 1 zeigt eine Schutzabdeckung in Form einer mäanderförmig verlaufenden Leitung mit zwei Anschlußpunkten A, B, die vorzugsweise in der obersten Metallage eines konventionellen Herstellprozesses für Halbleiterschaltungen realisiert wird. Die Anschlußpunkte A, B sind zur Schaltungsebene durchkontaktiert.

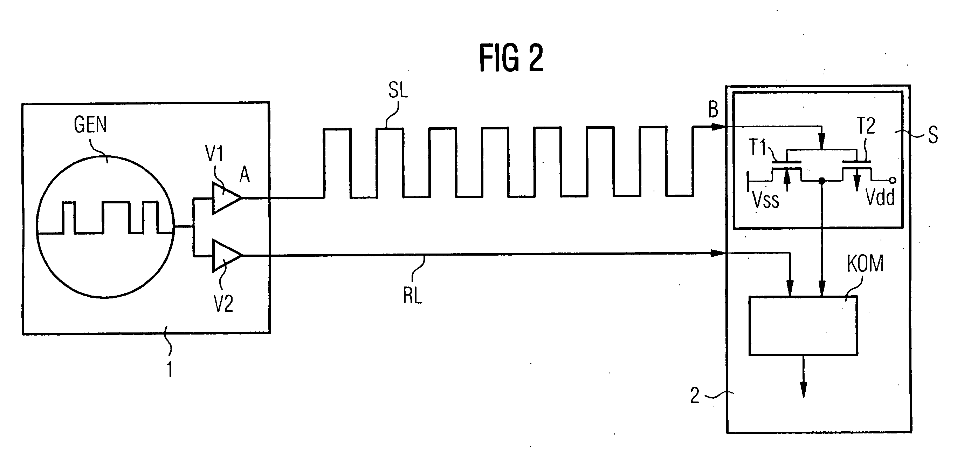

Sie können dort mit einer Schaltung verbunden sein, wie sie in Figur 2 dargestellt ist. Ein auf dem Halbleiterchip in einer Sendeeinrichtung 1 ausgebildeter Signalgenerator GEN erzeugt ein Signal, das im dargestellten Beispiel über Verstärker V1, V2 einer Schutzleitung SL, wie sie in Figur 1 dargestellt ist, und einer Referenzleitung RL zugeführt wird. Der Anschlußpunkt B der Schutzleitung ist mit den Gateanschlüssen zweier als CMOS-Inverter geschalteter Transistoren T1, T2 mit dünner Gateoxidschicht, die als Schutzsensor SS wirken, verbunden. Der Ausgang des Schutzsensors SS ist ebenso wie der zweite Anschluß der Referenzleitung RL mit einem der Eingänge eines Komparators KOM verbunden, dessen Ausgangssignal anzeigt, ob der Schutzsensor SS intakt ist oder nicht. Der Schutzsensor SS und der Komparator KOM bilden dabei eine Empfängerschaltung 2.

Wenn der Schutzsensor SS intakt ist liefert sein Ausgang das gleiche Signal wie die Referenzleitung RL. Ist der Schutzsensor jedoch aufgrund einer zu hohen Spannung infolge eines Ionenstrahlangriffs zerstört, liefert sein Ausgang konstant entweder eine logische Eins oder eine logische Null, was durch den Komparator KOM erkannt wird. Das Ausgangssignal des Komparators KOM bewirkt, daß die eigentliche auf dem Halbleiterchip realisierte Schaltung ihre bestimmungsgemäße Funktion nicht mehr erfüllen kann.

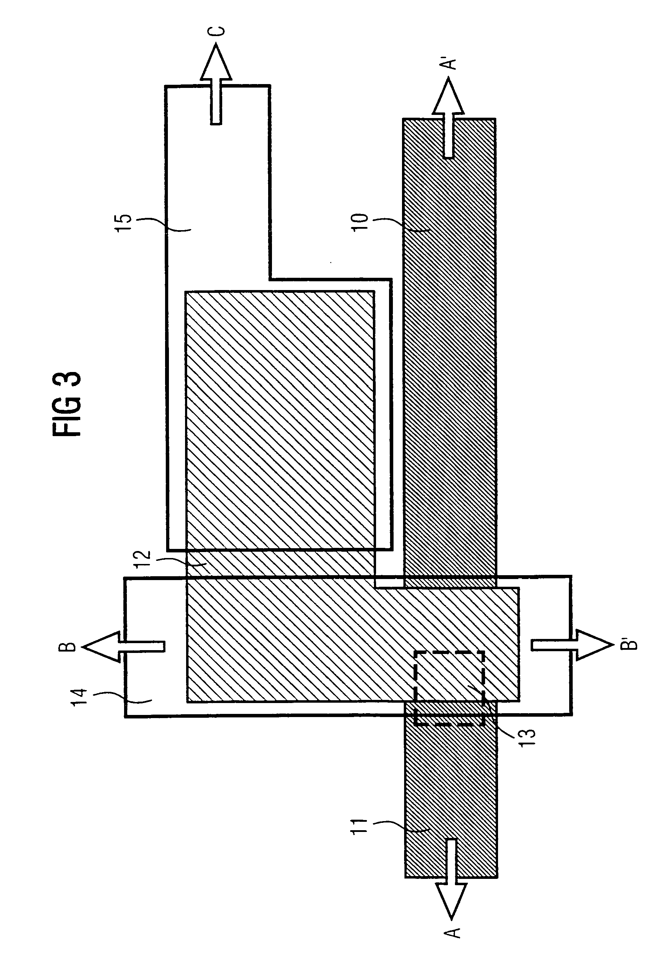

In Figur 3 ist eine Draufsicht auf eine prinzipielle Darstellung einer erfindungsgemäßen nicht-flüchtigen Speicherzelle mit zwei Steuergateelektroden gezeigt. Zwischen zwei Diffusionsgebieten 10, 11, die als Drain und Source eines Feldeffekttransitors fungieren ist in bekannter Weise ein nicht näher bezeichneter Kanalbereich ausgebildet, der von einem Teilbereich einer isolierten Gateelektrode 12 - einem sogenannten floating gate - bedeckt. Die isolierende Schicht zwischen dem Kanalbereich und dem Source- bzw. Drainbereich 11 einerseits und der isolierten Gateelektrode 12 andererseits ist in einem kleinen Bereich besonders dünn und bildet dort ein Tunnelfenster 13. Über einem ersten Bereich der isolierten Gateelektrode 12 ist eine erste Steuergateelektrode 14 und über einem zweiten Bereich einen zweite Steuergateelektrode 15 angeordnet. Das Diffusionsgebiet 10, 11 und die Steuergateelektroden 14, 15 weisen Anschlüsse A, A', B, B' bzw. C auf.

Die neuartige Speicherzelle kann in vorteilhafter Weise statt der Transistoren mit dünnem Gateoxid gemäß Figur 2 verwendet werden. Dabei ist dann der Anschluß C der Speicherzelle mit dem Anschluß B der Schutzleitung SL zu verbinden. Der Anschluß B der Speicherzelle und die Anschlüsse der Diffusionsgebiete A, A' der Speicherzelle werden einerseits zum Aufbringen einer Vorladung auf die isolierte Gateelektrode verwendet und sind andererseits zum Auswerten des Ladezustandes der isolierten Gateelektrode mit einer Auswerteschaltung AWS verbunden. Dies ist in Figur 4 dargestellt.

Die Vorladung wird in vorteilhafter Weiterbildung der Erfindung vor der Auslieferung der Halbleiterchips während der Testphase durch Anlegen einer hohen Programmierspannung von beispielsweise 16V zwischen einen der Anschlüsse B oder B' der ersten Steuergateelektrode 14 und den Anschluß A des Diffusionsgebiets 11 auf die isolierte Gateelektrode aufgebracht. Durch diese Ladung stellt sich eine bestimmte Einsatzspannung des Speichertransistors ein. Die Einsatzspannung ist damit ein Maß für die Ladung auf der isolierten Gateelektrode. Erfolgt nun ein FIB-Angriff, so baut sich zwischen der zweiten Steuergateelektrode 15 und dem Kanalbereich eine Spannung auf. Diese Spannung führt zu einem Tunnelstrom durch das Tunnelfenster 13 und damit zu einer Änderung der Ladung auf der isolierten Gateelektrode 12. Diese Änderung der Ladung kann durch Bestimmung der Einsatzspannung durch Anlegen einer sich ändernden Lesespannung an die erste Steuergateelektrode 14 durch die Auswerteschaltung AWS detektiert werden. Eine geänderte Einsatzspannung bedeutet, daß die Ladung auf der isolierten Gateelektrode verändert wurde.

Wurde auf diese Weise ein FIB-Angriff nicht-flüchtig festgehalten, können bei der nächsten Inbetriebnahme des Halbleiterchips geeignete Abwehrmechanismen aktiviert werden.

Auf die isolierte Gateelektrode 12 können als Vorladung sowohl positive als auch negative Ladungen und bei verschiedenen Schutzsensoren auch Ladungen unterschiedlicher Anzahl und Polarität aufgebracht werden um die Sicherheit der Detektion eines FIB-Angriffs zu erhöhen.

Der besondere Vorteil der erfindungsgemäßen Verwendung einer Schutzschicht in Verbindung mit einem Schutzsensor liegt darin, daß der Schutzsensor eine Ionenstrahluntersuchung der Schutzschicht nicht-flüchtig speichert und somit auch eine nachträgliche Reparatur der Schutzschicht oder entsprechende Bypassleitungen keine bestimmungsgemäße Funktion des Halbleiterchips mehr herbeiführen können.

## Patentansprüche

1. Halbleiterchip mit in zumindest einer Schicht eines Halbleitersubstrats realisierten, in zumindest einer Gruppe angeordneten Schaltungen und mit zumindest einer leitenden, über zumindest einer solchen Schaltungsgruppe angeordneten und mit zumindest einer der Schaltungen (1, 2) elektrisch verbundenen Schutzschicht (SL),
**dadurch gekennzeichnet,**
**daß** das Substrat zumindest einen Schutzsensor (SS) aufweist, der derart gebildet ist, daß er einen Zustand nicht-flüchtig speichern kann,
und **daß** der Schutzsensor (SS) mit seinem Detektionsanschluß mit der leitenden Schutzschicht (SL) oder zumindest einer der leitenden Schutzschichten verbunden ist und ein Ausgangsanschluß des Schutzsensors (SS) mit zumindest einer der Schaltungen (2) derart verbunden ist, daß eine bestimmungsgemäße Funktion der Schaltung nicht möglich ist, wenn am Ausgang des Schutzsensors ein definiertes, nicht-flüchtiges Signal anliegt.

2. Halbleiterchip nach Anspruch 1, **dadurch gekennzeichnet, daß** ein Schutzsensor (SS) mit zumindest einem Transistor (T1, T2) mit gegenüber Transistoren der Schaltungen sehr dünnem Gateoxid gebildet ist und der Gateanschluß des Transistors (T1, T2) mit der leitenden Schicht (SL) verbunden ist.

3. Halbleiterchip nach Anspruch 1, **dadurch gekennzeichnet, daß** ein Schutzsensor als nicht-flüchtige Speicherzelle ausgebildet ist, die mit beidseitig eines Kanalgebiets in einem Halbleitersubstrat ausgebildeten Source- und Drain-Diffusionsgebieten (10, 11) sowie einer vollständig isolierten, zumindest zum Teil oberhalb des Kanalgebiets angeordneten Gateelektrode (12) und zwei oberhalb der isolierten Gateelektrode (12) angeordneten Steuergateelektroden (14, 15) gebildet ist, wobei eine der Steuergateelektroden den Detektionsanschluß (15) bildet und die andere Steuergateelektrode (14) sowie die Diffusionsgebiete (10, 11) mit einer Auswerteschaltung (AWS) verbunden sind.

4. Halbleiterchip nach Anspruch 3, **dadurch gekennzeichnet, daß** die isolierte Gateelektrode (12) mit einer positiven oder einer negativen Ladung vorgeladen ist.

5. Halbleiterchip nach Anspruch 4, **dadurch gekennzeichnet, daß** bei mehreren Schutzsensoren die verschiedenen isolierten Gateelektroden (12) mit unterschiedlichen Ladungen vorgeladen sind.

6. Halbleiterchip nach einem der vorhergehenden Ansprüche, **dadurch gekennzeichnet, daß** zumindest eine der Schaltungen wenigstens eine Detektionsschaltung (KOM) aufweist, die mit dem Ausgangsanschluß des Schutzsensors (SS) verbunden ist.

## Claims

1. Semiconductor chip having circuits which are produced in at least one layer of a semiconductor substrate and are arranged in at least one group, and having at least one conductive protective layer (SL) which is arranged above at least one such circuit group and is electrically connected to at least one of the circuits (1, 2),
**characterized**
**in that** the substrate has at least one protective sensor (SS) which is formed such that it is able to store a state in nonvolatile fashion,
and **in that** the detection connection of the protective sensor (SS) is connected to the conductive protective layer (SL) or to at least one of the conductive protective layers, and an output connection of the protective sensor (SS) is connected to at least one of the circuits (2) such that the circuit cannot operate properly if there is a defined, nonvolatile signal at the output of the protective sensor.

2. Semiconductor chip according to Claim 1, **characterized in that** a protective sensor (SS) is formed using at least one transistor (T1, T2) which has a very thin gate oxide as compared with transistors in the circuits, and the gate connection of the transistor (T1, T2) is connected to the conductive layer (SL).

3. Semiconductor chip according to Claim 1, **characterized in that** a protective sensor is in the form of a nonvolatile memory cell which is formed using source and drain diffusion regions (10, 11) produced on both sides of a channel region in a semiconductor substrate, and also using a fully insulated gate electrode (12), at least part of which is arranged above the channel region, and two control gate electrodes (14, 15) which are arranged above the insulated gate electrode (12), one of the control gate electrodes forming the detection connection (15), and the other control gate electrode (14) and also the diffusion regions (10, 11) being connected to an evaluation circuit (AWS).

4. Semiconductor chip according to Claim 3, **characterized in that** the insulated gate electrode (12) is given an initial charge using a positive or negative charge.

5. Semiconductor chip according to Claim 4, **characterized in that**, when there are a plurality of protective sensors, the various insulated gate electrodes (12) are given an initial charge using different charges.

6. Semiconductor chip according to one of the preceding claims, **characterized in that** at least one of the circuits has at least one detection circuit (KOM) which is connected to the output connection of the protective sensor (SS).

## Revendications

1. Puce à semi-conducteur comportant des circuits réalisés dans au moins une couche d'un substrat semi-conducteur et disposés en au moins un groupe et au moins une couche de protection conductrice (SL) disposée au-dessus d'au moins un tel groupe de circuits et reliée électriquement à au moins un des circuits (1, 2),
**caractérisée**
**en ce que** le substrat comporte au moins un capteur de protection (SS) qui est formé de façon à pouvoir mémoriser un état de façon non volatile, et
**en ce que** le capteur de protection (SS) est relié par sa borne de détection à la couche de protection conductrice (SL) ou au moins à l'une des couches de protection conductrices et une borne de sortie du capteur de protection (SS) est reliée à au moins un des circuits (2) de façon à interdire une fonction prescrite du circuit lorsqu'un signal défini non volatil est appliqué à la sortie du capteur de protection.

2. Puce à semi-conducteur selon la revendication 1, **caractérisée en ce qu'**un capteur de protection (SS) est constitué d'au moins un transistor (T1, T2) dont l'oxyde de grille est très mince par rapport à des transistors des circuits et la borne de grille du transistor (T1, T2) est reliée à la couche conductrice (SL).

3. Puce à semi-conducteur selon la revendication 1, **caractérisée en ce qu'**un capteur de protection est conformé en cellule de mémoire non volatile qui est constituée de régions de diffusion source et drain (10, 11) conformées des deux côtés d'une région de canal dans un substrat de semi-conducteur, ainsi que d'une électrode de grille (12) totalement isolée et disposée au moins en partie au-dessus de la région de canal et de deux électrodes de grille de commande (14, 15) disposées au-dessus de l'électrode de grille isolée (12), l'une des électrodes de grille de commande formant la borne de détection (15) et l'autre électrode de borne de grille de commande (14) ainsi que les régions de diffusion (10, 11) étant reliées à un circuit d'exploitation (AWS).

4. Puce à semi-conducteur selon la revendication 3, **caractérisée en ce que** l'électrode de grille isolée (12) est préchargée avec une charge positive ou une charge négative.

5. Puce à semi-conducteur selon la revendication 4, **caractérisée en ce que**, dans le cas où il y a plusieurs capteurs de protection, les différentes électrodes de grille isolées (12) sont préchargée avec des charges différentes.

6. Puce à semi-conducteur selon l'une des revendications précédentes, **caractérisée en ce qu'**au moins un des circuits comporte au moins un circuit de détection (KOM), qui est relié à la borne de sortie du capteur de protection (SS).
